Europäisches Patentamt

European Patent Office

Office européen des brevets

(19)

(11) Veröffentlichungsnummer: **0 200 053**

**A1**

(12) # EUROPÄISCHE PATENTANMELDUNG

(21) Anmeldenummer: 86104958.3

(22) Anmeldetag: 11.04.86

(51) Int. Cl.⁴: **H 03 K 17/95**

(30) Priorität: 24.04.85 DE 3514834

(43) Veröffentlichungstag der Anmeldung:
05.11.86 Patentblatt 86/45

(84) Benannte Vertragsstaaten:
DE FR GB IT

(71) Anmelder: **Siemens Aktiengesellschaft Berlin und München**
**Wittelsbacherplatz 2**
**D-8000 München 2(DE)**

(72) Erfinder: **Wiesgickl, Bernhard, Dipl.-Ing. (FH)**
**Nr. 258**
**D-8453 Vilseck(DE)**

(54) Induktiver Annäherungsschalter.

(57) Die Erfindung bezieht sich auf ein elektronisches, berührungslos arbeitendes Gerät, vorzugsweise Annäherungsschalter, mit einem von außen durch Gegenstände bedämpfbaren Schwingkreis (3) mit einem fremderregten Oszillator. Für die Schwingkreisamplitude ist hier eine Amplitudenregelung vorgesehen, die bei bedämpftem Annäherungsschalter wirksam ist.

FIG 1

EP 0 200 053 A1

Siemens Aktiengesellschaft
Berlin und München

Unser Zeichen
VPA 85 P 3142 E

0200053

Induktiver Annäherungsschalter

Die Erfindung bezieht sich auf ein elektronisches, berührungslos arbeitendes Gerät, vorzugsweise Annäherungsschalter, mit einem von außen durch Gegenstände bedämpfbaren Schwingkreis mit einem fremderregten Oszillator.

Bei einem bekannten Schaltgerät der obengenannten Art (DE-OS 32 21 888) ist zwar schon eine relativ hohe Schaltfrequenz erreichbar. Der vorliegenden Erfindung liegt die Aufgabe zugrunde, die Schaltfrequenz noch weiter zu erhöhen. Dies wird auf einfache Weise bei einem Schaltgerät der obengenannten Art dadurch erreicht, daß eine Amplitudenregelung für die Schwingkreisamplitude vorgesehen ist, die bei bedämpften Bero wirksam ist. Weitere vorteilhafte Ausgestaltungen des Gegenstandes der Erfindung sind den Unteransprüchen zu entnehmen.

Anhand der Zeichnung wird ein Ausführungsbeispiel gemäß der Erfindung beschrieben.

Es zeigen:
Fig. 1 ein Blockschaltbild des elektronischen Schaltgerätes,
Fig. 2 die Innenbeschaltung der Amplitudenregelung und
Fig. 3 die Empfindlichkeitskurve eines induktiven Näherungsschalters, relative Amplitude über Abstand.

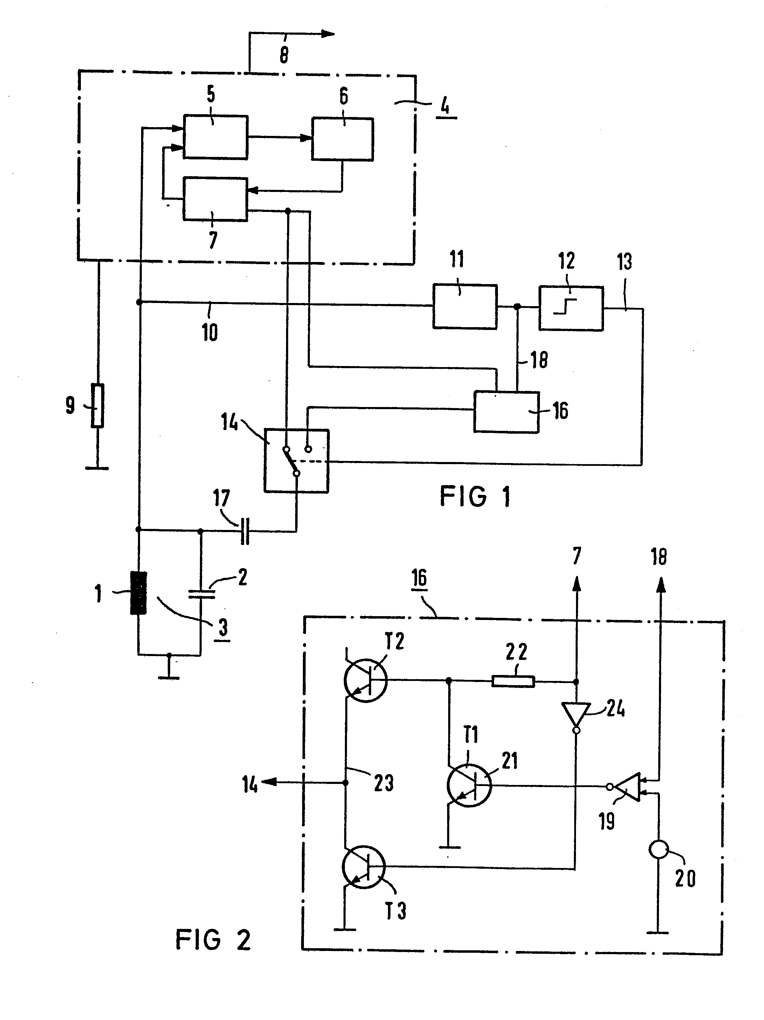

Die in Fig. 1 prinzipmäßig dargestellte Schaltungsanordnung für den Annäherungsschalter besteht aus dem aus der Spule 1 und dem Kondensator 2 bestehenden Schwingkreis 3, an dem der Phasenregelkreis 4 (PLL = Phase-locked Loop, wie aus der Zeitschrift "Der Elektroniker" Nr. 6, 1975 La 2 Syr / 15.04.1985 Seite EL 11, bekannt ist) angeschlossen ist. Der Phasenregelkreis besteht aus dem Phasendetektor 5, dem Schleifenfilter 6 und dem spannungsgesteuerten Oszillator
(VCO = voltage controlled oszillator) 7. Die Stromversorgung zwischen Phasenregelkreis 4 erfolgt über die Leitung
8 und den Widerstand 9. Die Leitung 10 wird an einen Demodulator 11, einen Schwellwertdetektor 12 oder auch
Trigger angeschlossen. Der Ausgang 13 wird - wie aus der
DE-PS 30 16 821 bekannt ist - mit dem eigentlichen Schaltgerät und der Spannungsversorgung zusammengeschaltet. Von
dem Ausgang 13 abhängig wird ein elektronischer Schalter
14 umgeschaltet, der einerseits mit dem Ausgang des VCO 7
und andererseits mit dem Ausgang 15 der Amplitudenregelung
16 zusammengeschaltet ist. Der Hauptausgang des elektronischen Schalters 14 ist über einen Kondensator 17 an den
Schwingkreis 3 angekoppelt. Die Verbindungslinie 18 zwischen Demodulator 11 und Schwellwertschalter 12 liegt
am Eingang der Amplitudenregelung 16. Sie führt auf einen
Differenzverstärker 19, an dem eine Referenzspannung 20
anliegt. Der Ausgang des Differenzverstärkers 19 liegt an
einem Transistor 21, der das über einen Widerstand 22 am
Transistor 21 liegende VCO-Signal beeinflußt. Der Gegentaktausgang 23 liegt an dem elektronischen Schalter 14. Vor
dem Widerstand 22 ist ein Inverter 24 angeschlossen, der
die Gegentaktstufe 23 steuert. Der Demodulator 11 liefert
eine zur Schwingkreisspannung proportionale Gleichspannung.
Der Ausgang des Demodulators 11 steuert über einen Schwellwertschalter 12 den Ausgang 13, wenn eine bestimmte Amplitude am Schwingkreis (Schaltpunkt) unterschritten wird,
d.h. derSchalter ist bedämpft. Der Ausgang 13 gibt einen
elektronischen Schalter 14 frei, der den Ausgang 15 der
Amplitudenregelung auf den Kondensator 17 schaltet. Die
vom Demodulator 11 gelieferte Gleichspannung liegt am
Pluseingang des Differenzverstärkers 19 an. Der Minuseingang des Differenzverstärkers 19 liegt an der Referenzspannung 20, auf die die Schwingkreisspannung bei bedämpftem Schaltgerät ausgeregelt werden soll. Steigt z.B.

0200053

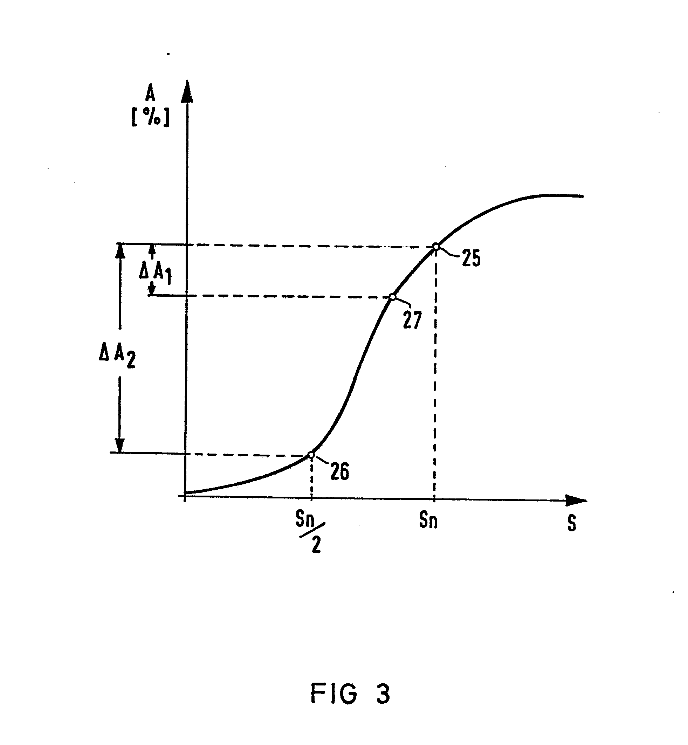

die Schwingkreisspannung über die Referenzspannung 20 an, wird der Transistor 21 weiter aufgesteuert, wodurch die auf den Schwingkreis eingekoppelte VCO-Spannung reduziert wird. Sinkt die Schwingkreisspannung unter den Wert von der Referenzspannung 20, wird der Transistor 21 stärker gesperrt, wobei die in den Schwingkreis eingekoppelte VCO-Spannung erhöht wird. So wird, wie oben beschrieben, bei bedämpftem Schaltgerät die Schwingkreisamplitude konstant gehalten. In Fig. 3 ist die Empfindlichkeitskurve eines indutkiven Näherungsschalters dargestellt. Hier ist aufgezeigt die relative Schwingkreisamplitude über dem Schaltabstand. Der Punkt 25 auf der Kurve entspricht der relativen Amplitude beim Schaltpunkt. Der Punkt 26 entspricht der relativen Amplitude bei halbem Schaltabstand gemäß Norm zur Ermittlung der Schaltfrequenz. Punkt 27 stellt den Punkt dar, der der Schwingkreisamplitude entspricht, die durch die Amplitudenregelung eingehalten wird. Fig. 3 zeigt, daß die Schaltfre- quenz bei einem Schalter gemäß der Erfindung gegenüber bekannten Schaltern höher ist. Die nötige Amplitudenän- derung $\Delta A_1$ über $\Delta A_2$ wird wesentlich geringer.

4 Patentansprüche

3 Figuren

Patentansprüche

1. Elektronisches, berührungslos arbeitendes Gerät, vorzugsweise Annäherungsschalter, mit einem von außen durch Gegenstände bedämpfbaren Schwingkreis mit einem fremderregten Oszillator, d a d u r c h   g e k e n n - z e i c h n e t ,   daß eine Amplitudenregelung (16) für die Schwingkreisamplitude vorgesehen ist, die bei bedämpftem Annäherungsschalter wirksam ist.

2. Gerät nach Anspruch 1, d a d u r c h   g e k e n n - z e i c h n e t ,   daß zur Zuschaltung der Amplitudenregelung (16) ein elektronischer Schalter (14) vorgesehen ist.

3. Gerät nach Anspruch 1 oder 2, d a d u r c h   g e - k e n n z e i c h n e t ,   daß die Schwingkreisspannung einem Demodulator (11) zugeführt ist, der ein der Schwingkreisspannung proportionales Gleichspannungssignal abgibt, das mit einer Referenzspannung (20) einem Differenzverstärker (19) zugeschaltet ist.

4. Gerät nach Anspruch 3, d a d u r c h   g e k e n n - z e i c h n e t ,   daß der Differenzverstärkerausgang die Amplitude eines VCO (7) (voltage controlled oszillator)-Signals regelt, das dem Schwingkreis (3) über eine Gegentaktstufe (23) zugeschaltet ist.

FIG 1

FIG 2

2/2

FIG 3

# EUROPÄISCHER RECHERCHENBERICHT

Europäisches
Patentamt

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl 4) |
|---|---|---|---|
| A | EP-A-0 096 332 (SIEMENS) * Seite 3, Zeile 19 - Seite 5; Figur * & DE - A - 3 221 888 (Kat. D) | 1 | H 03 K 17/95 |
| A | GB-A-2 075 201 (HONEYWELL) * Seite 1, Zeile 116 - Seite 3, Zeile 26; Figur 2 * & DE - A - 3 016 821 (Kat. D) | 1 | |

RECHERCHIERTE
SACHGEBIETE (Int Cl.4)

H 03 K

Der vorliegende Recherchenbericht wurde für alle Patentansprüche erstellt

| Recherchenort DEN HAAG | Abschlußdatum der Recherche 22-07-1986 | Prüfer CANTARELLI R.J.H. |
|---|---|---|